# EUROPÄISCHE PATENTANMELDUNG

(11) **EP 4 818 720 A1**
(43) Veröffentlichungstag der Anmeldung: **07.10.2026**
(21) Anmeldenummer: 26166084.9
(22) Anmeldetag: 19.03.2026
(51) Int. Cl.: G01R 31/385, G01R 1/04, H01M 10/42

(54) **BATTERIEPRÜFSTAND UND SYSTEM ZUM PRÜFEN VON BATTERIEN**

(30) Priorität: 26.03.2025 DE 102025111626
(71) Anmelder: ZF Friedrichshafen AG, 88046 Friedrichshafen (DE)
(72) Erfinder: DENK, Alexander, 94545 Hohenau (DE); RUTZHOFER, Nico, 94051 Hauzenberg (DE)
(74) Vertreter: ZF Friedrichshafen AG

(57) **Zusammenfassung**

Die Erfindung betrifft einen Batterieprüfstand (100) zum Prüfen von Batterien (200, 201), wobei der Batterieprüfstand (100) eine Prüfzelle (110), mindestens zwei elektrische Leistungsquellen (120, 121) und mindestens vier Stromschienen (130, 131, 132, 133) umfasst, wobei die mindestens zwei elektrischen Leistungsquellen (120, 121) jeweils zur Bereitstellung einer elektrischen Spannung und zur Bereitstellung eines elektrischen Stroms ausgebildet sind und wobei die mindestens vier Stromschienen (130, 131, 132, 133) zur elektrischen Verbindung der mindestens zwei elektrischen Leistungsquellen (120, 121) mit jeweils einer zu prüfenden Batterie (200, 201) ausgebildet sind, wobei die Prüfzelle (110) zur Aufnahme und Anordnung der mindestens vier Stromschienen (130, 131, 132, 133) ausgebildet ist. Der erfindungsgemäße Batterieprüfstand (100) zeichnet sich dadurch aus, dass der Batterieprüfstand (100) weiterhin mindestens eine Schienenbrücke (150, 151, 152, 155) umfasst, wobei die mindestens eine Schienenbrücke (150, 151, 152, 155) dazu ausgebildet ist, eine Batterie (200, 201) gleichzeitig mit den mindestens zwei elektrischen Leistungsquellen (120, 121) zu verbinden, so dass die mindestens zwei elektrischen Leistungsquellen (120, 121) parallel geschaltet sind.

## Beschreibung

Die Erfindung betrifft einen Batterieprüfstand zum Prüfen von Batterien gemäß dem Oberbegriff von Anspruch 1 sowie ein entsprechendes System.

Im Stand der Technik ist es bekannt, Kraftfahrzeuge mit vollständig elektromotorischem Antrieb oder mit einem sog. Hybridantrieb auszustatten. Dabei dient eine Batterie, die auch als Traktionsbatterie bezeichnet wird, zur Versorgung eines Elektromotors oder mehrerer Elektromotoren mit elektrischer Leistung, um das Kraftfahrzeug mittels des Elektromotors oder mittels mehrerer Elektromotoren anzutreiben. Während der Herstellung derartiger Batterien werden diese vielfältigen Tests unterzogen. Unter anderem findet eine Leistungsprüfung der Batterie statt, die die Funktionstüchtigkeit und Funktionssicherheit im Rahmen einer End-of-Line Prüfung sicherstellt. Dabei wird eine zu prüfende Batterie beispielsweise in kurzer Zeit mehrfach geladen und wieder entladen.

Im Rahmen dieser Leistungsprüfungen ist es wichtig, dass zuverlässige Verbindungen zur Übertragung elektrischer Leistungen hergestellt werden, um die zu prüfende Batterie mit den Testvorrichtungen zu verbinden. Hierbei ist es bekannt, z.B. für jeden Pol einer Batterie einen Steckverbinder mit einem einzelnen Pin und mit einer einzelnen Kontaktbuchse bereitzustellen, wobei die Kontaktierungen z.B. mittels Thermofühlern oder anderen Sensoren überwacht werden können.

In diesem Zusammenhang sind aus der DE 10 2020 118 231 A1 ein Batterieprüfstand sowie ein Verfahren zur Prüfung einer Batteriezelle bekannt. Der Batterieprüfstand umfasst eine Halterung zur Aufnahme einer Batteriezelle, eine elektrische Ladevorrichtung, die elektrisch mit der Batteriezelle verbunden ist, sowie eine Vorrichtung zur Erfassung von Volumenänderungen der Batteriezelle.

Die DE 10 2013 012 219 B3 offenbart einen Batterieprüfstand zum Prüfen von mindestens zwei Batterien. Dazu weist der Batterieprüfstand einen Batterietester, einen Schütz mit mindestens einer ersten und einer zweiten Schaltstufe und eine Steuerung zum Steuern des Schützes auf. Der Schütz ist dazu vorbereitet, in der ersten Schaltstufe eine erste Batterie mit dem Batterietester zu verbinden und eine zweite Batterie von dem Batterietester zu trennen. In der zweiten Schaltstufe ist der Schütz dazu vorgesehen, die zweite Batterie mit dem Batterietester zu verbinden und die erste Batterie von dem Batterietester zu trennen.

Aus der EP 2 544 295 A1 ist ein Batterieprüfstand bekannt, der eine Prüfzelle, in welcher eine zu prüfende Batterie angeordnet ist, eine Halterung, welche in der Prüfzelle angeordnet ist, und in der Lage ist, die Batterie aufzunehmen, eine Regelungseinheit, welche mit einer in der Halterung angeordneten Batterie verbindbar ist, wenigstens eine Sensoreinrichtung zur Überwachung der Batterie, wobei die Sensoreinrichtung mit der Regelungseinheit verbunden ist, und eine Kühlvorrichtung, welche mit der Regelungseinheit verbunden ist und welche ausgelegt ist, in einer Gefahrensituation die Batterie in der Prüfzelle von außen zu kühlen, umfasst.

Die bekannten Batterieprüfstände sind jedoch dahingehend nachteilig, als dass sie nicht oder nur in sehr geringem Maße an wechselnde Prüferfordernisse anpassbar sind.

Es ist eine Aufgabe der vorliegenden Erfindung, einen verbesserten Batterieprüfstand zum Prüfen von Batterien vorzuschlagen.

Diese Aufgabe wird erfindungsgemäß durch den Batterieprüfstand zum Prüfen von Batterien gemäß Anspruch 1 gelöst. Vorteilhafte Ausgestaltungen ergeben sich aus den Unteransprüchen.

Die Erfindung betrifft einen Batterieprüfstand zum Prüfen von Batterien, insbesondere Hochvoltbatterien, wie sie beispielsweise in Elektrofahrzeugen eingesetzt werden.

Der Batterieprüfstand umfasst hierzu eine Prüfzelle, mindestens zwei elektrische Leistungsquellen und mindestens vier Stromschienen, wobei die mindestens zwei elektrischen Leistungsquellen jeweils zur Bereitstellung einer elektrischen Spannung und zur Bereitstellung eines elektrischen Stroms ausgebildet sind, wobei die mindestens vier Stromschienen zur elektrischen Verbindung der mindestens zwei elektrischen Leistungsquellen mit jeweils einer zu prüfenden Batterie ausgebildet sind und wobei die Prüfzelle zur Aufnahme und Anordnung der mindestens vier Stromschienen ausgebildet ist.

Die Erfindung betrifft also einen Batterieprüfstand zum Prüfen von insbesondere Batterien für Elektrofahrzeuge oder anderen elektrischen Speichern.

Der Batterieprüfstand umfasst, wie beschrieben, u.a. eine Prüfzelle, in welcher bevorzugt alle Stromschienen und elektrischen Kontakte zu oder von den Stromschienen angeordnet sind. Die Prüfzelle gewährleistet dabei, dass Unfälle durch einen unbeabsichtigten Kontakt von Bedienpersonal des Prüfstands mit unter elektrischer Spannung stehenden Teilen des Prüfstands zuverlässig vermieden werden können.

Darüber hinaus kann der Prüfstand auch weitere Elemente umfassen, wie beispielsweise eine Klimakammer, eine Konditionierung, Schaltschränke, Sensoren und eine oder mehrere Steuereinheiten.

Vorteilhaft sind außerhalb der Prüfzelle keine elektrisch leitenden bzw. unter Spannung stehenden Teile des Batterieprüfstands zugänglich.

Die mindestens vier Stromschienen stellen dabei vorteilhaft jeweils paarweise einen Pluspfad und einen Minuspfad für jeweils eine zu prüfende Batterie dar, um die zu prüfende Batterie mit einer der Leistungsquellen elektrisch zu verbinden.

Der Batterieprüfstand kann somit beispielsweise zwei Batterien gleichzeitig prüfen, wobei jede der zwei Batterien mit jeweils einer Leistungsquelle verbunden ist.

Erfindungsgemäß ist es nun vorgesehen, dass der Batterieprüfstand weiterhin mindestens eine Schienenbrücke umfasst, wobei die mindestens eine Schienenbrücke dazu ausgebildet ist, eine einzelne Batterie gleichzeitig mit den mindestens zwei elektrischen Leistungsquellen zu verbinden, so dass die mindestens zwei elektrischen Leistungsquellen parallel geschaltet sind.

Ein Vorteil der Erfindung liegt somit darin, dass durch die Parallelschaltung der Leistungsquellen mittels der Schienenbrücke eine flexible Anpassung der Prüfbedingungen an verschiedene Batterien bzw. an verschiedene Prüferfordernisse ermöglicht wird. Insbesondere können durch die parallele Verschaltung hohe Prüfströme realisiert werden, ohne dass hierfür auf spezielle, besonders leistungsstarke Leistungsquellen zurückgegriffen werden müsste. Dies führt sowohl zu einer Reduzierung der Investitionskosten als auch zu einer Erhöhung der Skalierbarkeit und Anpassbarkeit des Prüfstands an unterschiedliche Anforderungen.

Insgesamt wird somit ein flexibler, sicherer und effizienter Batterieprüfstand bereitgestellt, welcher für vielfältige Prüferfordernisse ausgelegt ist.

Gemäß einer vorteilhaften Ausführungsform der Erfindung ist es vorgesehen, dass die mindestens eine Schienenbrücke einen Pluspfad und einen Minuspfad aufweist, wobei der Pluspfad und der Minuspfad über ein Verbindungselement aus nicht leitendem Material gehalten und zueinander beabstandet sind.

Besonders bevorzugt ist es vorgesehen, dass das nichtleitende Material ein Kunststoff ist.

Das Verbindungselement dient dabei nicht nur der mechanischen Fixierung, sondern gewährleistet gleichzeitig auch eine sichere elektrische Isolation zwischen den Strompfaden. Hierdurch wird einerseits die elektrische Sicherheit erhöht und andererseits eine exakte Positionierung der Plus- und Minuspfade zueinander sichergestellt.

Außerdem vereinfacht das Verbindungselement die Montage der Parallelschaltschieneneinheit, da die Pfade bereits vorpositioniert sind und somit Montagefehler minimiert werden.

Gemäß einer weiteren vorteilhaften Ausführungsform der Erfindung ist es vorgesehen, dass die mindestens eine Schienenbrücke ein definiertes Muster an Öffnungen aufweist, wobei ein erster Anteil der Öffnungen zur Kontaktierung der mindestens vier Stromschienen an deren Kontaktstellen ausgebildet ist und wobei ein zweiter Anteil der Öffnungen als Kontaktstellen zur elektrischen Verbindung mit einer zu prüfenden Batterie ausgebildet ist.

Ein Vorteil dieser Ausführungsform liegt darin, dass durch das definierte Muster an Öffnungen eine eindeutige und fehlerfreie Zuordnung der Verbindungen zwischen der Schienenbrücke sowie den Stromschienen sichergestellt wird. Dadurch wird das Risiko von Fehlanschlüssen größtenteils ausgeschlossen, was wiederum sowohl die Sicherheit als auch die Zuverlässigkeit des Prüfprozesses verbessert. Das definierte Muster der Öffnungen reduziert den zeitlichen Aufwand für Rüst- und Montagearbeiten.

Gemäß einer weiteren vorteilhaften Ausführungsform der Erfindung ist es vorgesehen, dass die mindestens eine Schienenbrücke über den ersten Anteil der Öffnungen mit den Kontaktstellen der mindestens vier Stromschienen verschraubbar ist.

Diese Ausführungsform bietet den Vorteil, dass eine stabile mechanische Verbindung geschaffen wird, die eine zuverlässige elektrische Kontaktierung gewährleistet.

Gleichzeitig ermöglicht die Verschraubung eine einfache Montage und Demontage der Schienenbrücke, wodurch Umrüstarbeiten schnell und unkompliziert durchgeführt werden können.

Gemäß einer weiteren vorteilhaften Ausführungsform der Erfindung ist es vorgesehen, dass die Prüfzelle Führungsbolzen zur Platzierung der mindestens einen Schienenbrücke aufweist.

Die Verwendung solcher Führungsbolzen bietet Vorteile bei der Montage bzw. bei Umrüstarbeiten, da sie eine schnelle, präzise und fehlerfreie Positionierung der Schienenbrücke ermöglichen.

Gemäß einer weiteren vorteilhaften Ausführungsform der Erfindung ist es vorgesehen, dass der Batterieprüfstand zwei zusätzliche Stromschienen aufweist, welche jeweils eine größere Querschnittsfläche aufweisen als jede der mindestens vier Stromschienen, wobei die zwei zusätzlichen Stromschienen dazu ausgebildet sind, mit insgesamt zwei Leistungsquellen elektrisch verbunden zu werden.

Diese zusätzlichen Stromschienen sind also speziell dazu ausgebildet, nicht nur mit einer, sondern mit zwei Leistungsquellen verbunden zu werden. Daraus ergibt sich der Vorteil, dass die zwei zusätzlichen Stromschienen beispielsweise eine Prüfung einer Batterie mit der doppelten Leistung einer Leistungsquelle ermöglichen.

Durch die vergrößerte Querschnittsfläche der zusätzlichen Stromschienen können besonders hohe elektrische Ströme sicher übertragen werden, wodurch Prüfungen mit erhöhten Stromstärken - beispielsweise durch zwei parallel geschaltete Leistungsquellen - realisierbar sind.

Es ist dabei gleichermaßen möglich, dass beide Leistungsquellen ein und demselben Batterieprüfstand zugeordnet sind oder dass die Leistungsquellen vollständig oder teilweise einem anderen Batterieprüfstand zugeordnet sind.

Somit liegt ein Vorteil dieser Ausführungsform auch darin, dass sie eine einfache und sichere Erweiterbarkeit bzw. Kaskadierung des Batterieprüfstands ermöglicht wird.

Die zusätzlichen Stromschienen erlauben nämlich auch eine einfache mechanische und elektrische Kopplung mehrerer Batterieprüfstände miteinander. Dies ermöglicht eine flexible Anpassung der Prüfkapazitäten an unterschiedlichste Anforderungen, ohne dass umfangreiche und zeitaufwändige Umbaumaßnahmen erforderlich sind.

Gemäß einer weiteren vorteilhaften Ausführungsform der Erfindung ist es vorgesehen, dass der Batterieprüfstand eine zusätzliche Schienenbrücke umfasst, wobei die zusätzliche Schienenbrücke dazu ausgebildet sind, die Batterie zusätzlich mit weiteren Leistungsquellen des weiteren Batterieprüfstands zu verbinden, so dass die mindestens zwei elektrischen Leistungsquellen und die weiteren Leistungsquellen parallel geschaltet sind.

Dies ermöglicht eine Parallelschaltung der mindestens zwei elektrischen Leistungsquellen des Batterieprüfstands mit weiteren Leistungsquellen anderer Batterieprüfstände, sodass die verfügbare Stromstärke für den Prüfprozess nochmals erheblich erhöht wird.

Ein Vorteil dieser Ausführungsform liegt somit auch darin, durch die zusätzliche Schienenbrücke besonders hohe Prüfströme zu realisieren, ohne auf andere, leistungsstärkere und teurere Leistungsquellen zurückgreifen zu müssen.

Die zusätzliche Schienenbrücke trägt somit wesentlich zur Skalierbarkeit und Flexibilität des Batterieprüfstands bei. Sie erlaubt es, auf wechselnde Anforderungen und Prüfbedingungen schnell und einfach zu reagieren.

Gemäß einer weiteren vorteilhaften Ausführungsform der Erfindung ist es vorgesehen, dass die zusätzliche Schienenbrücke ein definiertes Muster an Öffnungen aufweist, wobei ein erster Anteil der Öffnungen zur Kontaktierung der zwei zusätzlichen Stromschienen an deren Kontaktstellen ausgebildet ist, wobei ein zweiter Anteil der Öffnungen zur Kontaktierung der mindestens einen Schienenbrücke ausgebildet ist und wobei ein dritter Anteil der Öffnungen als Kontaktstellen zur elektrischen Verbindung mit einer zu prüfenden Batterie ausgebildet ist.

Ein Vorteil dieser Ausführungsform besteht darin, dass durch das klar definierte und speziell angeordnete Öffnungsmuster eine eindeutige und verwechslungssichere Zuordnung der elektrischen Verbindungen erreicht wird. Dies reduziert erheblich das Risiko von Montagefehlern, Kurzschlüssen oder Fehlverbindungen während der Umrüstung des Prüfstands.

Des Weiteren begünstigt diese Ausgestaltung eine einfache und schnelle Anpassung des Batterieprüfstands an wechselnde Anforderungen bezüglich unterschiedlicher Prüfszenarien oder Prüfbedingungen, da klar festgelegt ist, welche Komponenten in welcher Weise zu verbinden sind. Dies erhöht die Flexibilität und reduziert mögliche Fehlerquellen bei der Bedienung.

Gemäß einer weiteren vorteilhaften Ausführungsform der Erfindung ist es vorgesehen, dass die zusätzliche Schienenbrücke über den ersten Anteil der Öffnungen mit den Kontaktstellen der zwei zusätzlichen Stromschienen verschraubbar ist und über den zweiten Anteil der Öffnungen mit den Kontaktstellen der mindestens einen Schienenbrücke verschraubbar ist

Ein Vorteil dieser Ausführungsform liegt auch in diesem Fall darin, dass die Verschraubbarkeit über definierte Öffnungen eine besonders zuverlässige, mechanisch stabile und sichere elektrische Verbindung ermöglicht. Dies gewährleistet nicht nur eine zuverlässige elektrische Kontaktierung mit geringem Übergangswiderstand, sondern verhindert auch das unbeabsichtigte Lösen oder Lockern der Verbindungen während des Betriebs.

Gemäß einer weiteren vorteilhaften Ausführungsform der Erfindung ist es vorgesehen, dass die Prüfzelle Führungsbolzen zur Platzierung der zusätzlichen Schienenbrücke aufweisen.

Ein Vorteil dieser Ausgestaltung liegt darin, dass die Führungsbolzen eine einfache, schnelle und präzise Positionierung der zusätzlichen Schienenbrücke ermöglichen. Dadurch wird die Montage deutlich erleichtert und Montagefehler, die zu fehlerhaften elektrischen Verbindungen oder mechanischen Instabilitäten führen könnten, werden effektiv vermieden.

Gemäß einer weiteren vorteilhaften Ausführungsform der Erfindung ist es vorgesehen, dass der Batterieprüfstand einen ersten Schalter aufweist, wobei der erste Schalter dazu ausgebildet ist, bei einer Platzierung der mindestens einen Schienenbrücke automatisiert betätigt zu werden und /oder dass der Batterieprüfstand einen zweiten Schalter aufweist, wobei der zweite Schalter dazu ausgebildet ist, bei einer Platzierung der zusätzlichen Schienenbrücke automatisiert betätigt zu werden, wobei bei einer Betätigung des ersten Schalters eine Sperrung der mindestens zwei elektrische Leistungsquellen aufgehoben wird und wobei bei einer Betätigung des zweiten Schalters eine Sperrung der weiteren Leistungsquellen aufgehoben wird.

Ein Vorteil dieser Ausführungsform besteht darin, dass durch die automatisierte Betätigung der Schalter eine zuverlässige und unmittelbare Kontrolle der korrekten Montagekonfiguration gewährleistet wird. Dies erhöht die Sicherheit des Betriebs, da eine fehlerhafte Konfiguration erkannt und die elektrischen Leistungsquellen automatisch gesperrt werden, um Schäden an der Anlage und Gefährdungen des Bedienpersonals zu verhindern.

Darüber hinaus trägt die automatisierte Schalterbetätigung dazu bei, Wartungs- und Montagezeiten zu verkürzen, da eine manuelle Überprüfung oder zusätzliche Kontrolle der richtigen Montage entfällt. Dies resultiert in einer insgesamt verbesserten Effizienz des Prüfstands, geringeren Stillstandszeiten und reduziertem Umrüstungsaufwand.

Gemäß einer weiteren vorteilhaften Ausführungsform der Erfindung ist es vorgesehen, dass der Batterieprüfstand Spannungsmessstreckenvorrichtungen aufweist, welche dazu ausgebildet sind, Spannungsmesswerte der mindestens vier Stromschienen und der mindestens einen Parallelschieneneinheit zu erfassen und/oder Spannungsmesswerte der zwei weiteren Stromschienen und der zusätzlichen Parallelschieneneinheit zu erfassen und bei unerwarteten Spannungsmesswerten die mindestens zwei elektrischen Leistungsquellen zu sperren und/oder die weiteren Leistungsquellen zu sperren.

Ein Vorteil dieser Ausführungsform liegt darin, dass durch die kontinuierliche Überwachung der Spannungswerte eine unmittelbare und zuverlässige Erkennung unerwarteter Betriebszustände ermöglicht wird. Dadurch können potenzielle Fehlerzustände, wie etwa Fehlverbindungen, Kurzschlüsse oder unzulässige Spannungsabweichungen, frühzeitig erkannt und die elektrischen Leistungsquellen automatisiert gesperrt werden. Auch dies führt zu einer Erhöhung der Sicherheit des Prüfstands und somit zu einem verbesserten Schutz der angeschlossenen Prüflinge und des Bedienpersonals.

Darüber hinaus ermöglicht die Spannungsmessstreckenvorrichtung eine präzise Diagnose und Lokalisierung von Fehlerquellen, wodurch auch Wartungsarbeiten beschleunigt und vereinfacht werden. Durch die automatisierte Erfassung und Auswertung der Messwerte können Fehler automatisiert erkannt und behoben werden, was die Stillstandszeiten reduziert und die Gesamtverfügbarkeit des Batterieprüfstands verbessert.

Weiterhin verbessert diese Ausgestaltung die Dokumentation und Nachvollziehbarkeit des Prüfprozesses, da alle relevanten Spannungsdaten kontinuierlich und exakt erfasst werden. Dies erlaubt eine detaillierte Analyse und Optimierung der Prüfverfahren.

Gemäß einer weiteren vorteilhaften Ausführungsform der Erfindung ist es vorgesehen, dass der Batterieprüfstand eine transparente Schutzabdeckung umfasst, welche alle stromführenden Bauteile nach dem Öffnen einer Zugangstür berührungssicher abdeckt und fingersichere Öffnungen aufweist, um Spannungsmessungen im gesicherten Zustand zu ermöglichen.

Ein Vorteil dieser Ausführungsform liegt in der weiteren Erhöhung der Sicherheit für das Bedienpersonal. Durch die transparente Gestaltung der Schutzabdeckung bleibt dabei die visuelle Inspektion der stromführenden Bauteile jederzeit möglich, ohne dass eine direkte Berührung möglich wäre. Dies reduziert das Risiko von elektrischen Unfällen.

Die fingersicheren Öffnungen ermöglichen zudem eine sichere Spannungsmessung auch bei geöffneter Zugangstür, ohne dass die Schutzabdeckung entfernt werden muss. Dies verbessert nicht nur die Arbeitssicherheit, sondern erleichtert auch Wartungs- und Diagnosearbeiten, da notwendige Prüfungen sicher und schnell durchgeführt werden können.

Die Erfindung betrifft weiterhin ein System zum Prüfen von Batterien. Das erfindungsgemäße System zeichnet sich dadurch aus, dass es mindestens zwei erfindungsgemäße Batterieprüfstände umfasst.

Dies führt zu den bereits beschriebenen Vorteilen.

Ein weiterer Vorteil besteht zudem darin, dass durch die Verwendung mehrerer Batterieprüfstände gleichzeitig eine große Anzahl von Batterien oder komplexe Batterieanordnungen effizient und parallel getestet werden können. Dies reduziert die Gesamtdauer der Prüfprozesse und erhöht somit die Produktivität und Effizienz der Prüfabläufe.

Zudem können die Leistungsquellen mehrerer Batterieprüfstände parallel geschaltet werden, um eine Batterie bei besonders hohen Leistungen zu prüfen.

Gemäß einer weiteren vorteilhaften Ausführungsform der Erfindung ist es vorgesehen, dass die mindestens zwei Batterieprüfstände identisch ausgebildet sind.

Die Verwendung identischer Batterieprüfstände innerhalb des Systems bietet dabei Vorteile bezüglich der Modularität, Vereinheitlichung und Standardisierung.

Darüber hinaus ermöglicht die identische Ausgestaltung der Batterieprüfstände eine schnelle und unkomplizierte Erweiterung des gesamten Systems, da neue Batterieprüfstände problemlos hinzugefügt und integriert werden können. Diese Skalierbarkeit sorgt für eine hohe Flexibilität bei variierenden Prüfanforderungen und bietet die Möglichkeit, Kapazitäten kurzfristig und ohne große Anpassungen zu erweitern.

Nachfolgend wird die Erfindung anhand von in den Figuren dargestellten Ausführungsformen beispielhaft erläutert.

Es zeigen:
Fig. 1 beispielhaft und schematisch einen erfindungsgemäßen Batterieprüfstand zum Prüfen von Batterien,
Fig. 2 beispielhaft eine Schienenbrücke,
Fig.3 beispielhaft den Batterieprüfstand 100 der Fig. 1, wobei jedoch die Schienenbrücke in der Prüfzelle montiert ist,
Fig. 4 beispielhaft eine mögliche Ausführungsform eines erfindungsgemäßen Systems zum Prüfen von Batterien und
Fig. 5 beispielhaft eine zusätzliche Schienenbrücke.

Gleiche Gegenstände, Funktionseinheiten und vergleichbare Komponenten sind figurenübergreifend mit den gleichen Bezugszeichen bezeichnet. Diese Gegenstände, Funktionseinheiten und vergleichbaren Komponenten sind hinsichtlich ihrer technischen Merkmale identisch ausgeführt, sofern sich aus der Beschreibung nicht explizit oder implizit etwas anderes ergibt.

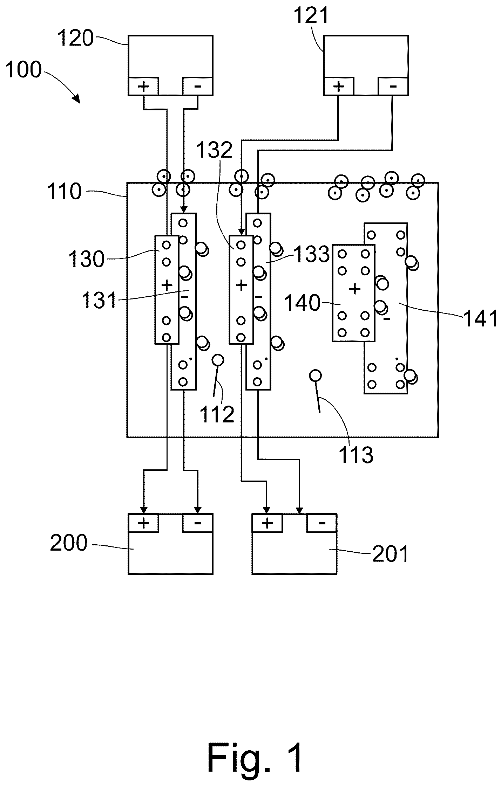

Fig. 1 zeigt beispielhaft und schematisch einen erfindungsgemäßen Batterieprüfstand 100 zum Prüfen von Batterien 200, 201.

Der Batterieprüfstand 100 der Fig. 1 umfasst beispielsgemäß eine Prüfzelle 110, zwei elektrische Leistungsquellen 120, 121 und vier Stromschienen 130, 131, 132, 133. Die vier Stromschienen 130, 131, 132, 133 sind dabei in der Prüfzelle 110 angeordnet und somit gegen die Umgebung abgeschirmt. Da die Stromschienen 130, 131, 132, 133 hohe elektrische Spannungen aufweisen können und hohe elektrische Ströme führen, geht von den Stromschienen 130, 131, 132, 133 grundsätzlich eine Gefahr für das Bedienpersonal des Batterieprüfstands 100 aus.

Beispielsgemäß weist die Prüfzelle 110 auch eine transparente Schutzabdeckung (nicht dargestellt in Fig. 1) auf, welche alle stromführenden Bauteile auch nach dem Öffnen einer Zugangstür (ebenfalls nicht dargestellt in Fig. 1) berührungssicher abdeckt.

Die zwei elektrischen Leistungsquellen 120, 121 sind dabei als Gleichspannungs- bzw. stromquellen 120, 121 ausgebildet und stellen jeweils eine Spannung und einen Strom bereit, mit denen Ladevorgänge und Entladevorgänge der Batterien 200, 201 ausgeführt werden können.

Beispielsgemäß kann jede Leistungsquelle 120, 121 jeweils einen elektrischen Strom von bis 1000 A bereitstellen. Grundsätzlich ist es jedoch auch möglich, dass eine Leistungsquelle 120, 121 dazu ausgebildet ist, einen höheren oder niedrigeren Strom bereitzustellen.

Die vier Stromschienen 130, 131, 132, 133 dienen zur elektrischen Verbindung der zwei elektrischen Leistungsquellen 120, 121 mit jeweils einer zu prüfenden Batterie 200, 201 und bestehen beispielsgemäß aus Kupfer.

Jeweils eine Stromschiene 130, 132 verbindet dabei ein Pluspol einer Leistungsquelle 120, 121 mit einem Pluspol einer zu prüfenden Batterie 200, 201. Die jeweils andere Stromschiene 131, 133 verbindet einen Minuspol einer Leistungsquelle 120, 121 mit einem Minuspol einer zu prüfenden Batterie 200, 201.

Wie weiterhin zu sehen ist, weist der Batterieprüfstand 100 zwei zusätzliche Stromschienen 140, 141 auf, welche ebenfalls innerhalb der Prüfzelle 110 angeordnet sind. Diese zusätzlichen Stromschienen 140, 141 bestehen beispielsgemäß ebenfalls aus Kupfer, weisen jedoch jeweils eine größere Querschnittsfläche auf als die vier Stromschienen 130, 131, 132, 133.

Dadurch sind die zusätzlichen Stromschienen 140, 141 dazu geeignet, höhere elektrische Ströme zu transportieren und können mit den zwei Leistungsquellen 120, 121 gleichzeitig verbunden werden.

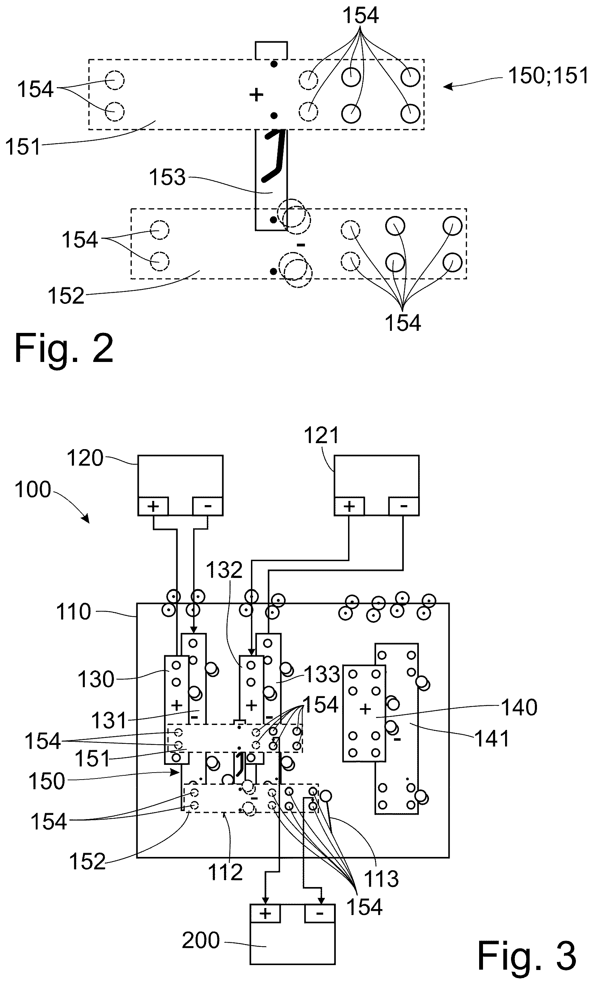

Der Batterieprüfstand 100 umfasst weiterhin auch eine in Fig. 2 dargestellte Schienenbrücke 150, die in der Darstellung der Fig. 1 jedoch nicht montiert ist.

Die Schienenbrücke 150 ist dazu ausgebildet, eine der beiden Batterien 200, 201 gleichzeitig mit den zwei elektrischen Leistungsquellen 120, 121 zu verbinden, so dass die zwei elektrischen Leistungsquellen 120, 121 parallel geschaltet sind.

Die Schienenbrücke 150 weist einen Pluspfad 151 und einen Minuspfad 152 auf, wobei der Pluspfad 151 und der Minuspfad 152 über ein Verbindungselement 153 aus nicht leitendem Material gehalten und zueinander beabstandet sind. Beispielsgemäß handelt es sich bei dem nicht leitenden Material um einen Kunststoff.

Wie weiterhin zu sehen ist, weist die Schienenbrücke 150 ein definiertes Muster an Öffnungen 154 auf, wobei ein erster Anteil der Öffnungen 154 zur Kontaktierung der vier Stromschienen 130, 131, 132, 133 an deren Kontaktstellen ausgebildet ist und wobei ein zweiter Anteil der Öffnungen 154 als Kontaktstellen zur elektrischen Verbindung mit der zu prüfenden Batterie 200, 201 ausgebildet ist.

Beispielsgemäß kann die Schienenbrücke 150 über den ersten Anteil der Öffnungen 154 dabei mit den Stromschienen 130, 131, 132, 133 verschraubt werden.

Die Prüfzelle 110 weist zudem Führungsbolzen zur Platzierung der Stromschienen 130, 131, 132, 133 und der Schienenbrücke 150 auf.

Weiterhin weist der Batterieprüfstand 100 in der Prüfzelle 110 einen ersten Schalter 112 und einen zweiten Schalter 113 auf, die dazu ausgebildet ist, sind einer Platzierung der mindestens einen Schienenbrücke 150 automatisiert betätigt zu werden.

Bei einer Betätigung des ersten Schalters 112 durch die Schienenbrücke 150 wird eine Sperrung der zwei elektrische Leistungsquellen 120, 121 aufgehoben, so dass ein Prüfvorgang mittels der zwei elektrischen Leistungsquellen 120, 121 erfolgen kann. Somit ist sichergestellt, dass der Prüfvorgang erst dann erfolgen kann, wenn die Schienenbrücke 150 korrekt montiert und der erste Schalter 112 betätigt wird.

Im ausgewählten Betriebsmodus der Fig. 1 muss der zweite Schalter 113 nicht betätigt werden.

Fig. 3 zeigt den Batterieprüfstand 100 der Fig. 1, wobei jedoch die Schienenbrücke 150 in der Prüfzelle 110 montiert ist. Wie zu sehen ist, verbindet der Pluspfad 151 die beiden positiven Stromschienen 130, 132 miteinander und der Minuspfad 152 verbindet die beiden negativen Stromschienen 131, 133 miteinander. Über den zweiten Anteil von Öffnungen 154, die als Kontaktstellen zur elektrischen Verbindung mit der zu prüfenden Batterie 200 ausgebildet ist, sind somit beide Leistungsquellen 120, 121 mit einer einzelnen Batterie 200 verbunden, wobei die Leistungsquellen 120, 121 parallel geschaltet sind. Somit kann die Batterie 200 mit der doppelten Stromstärke, beispielsgemäß 2000 A, geprüft werden.

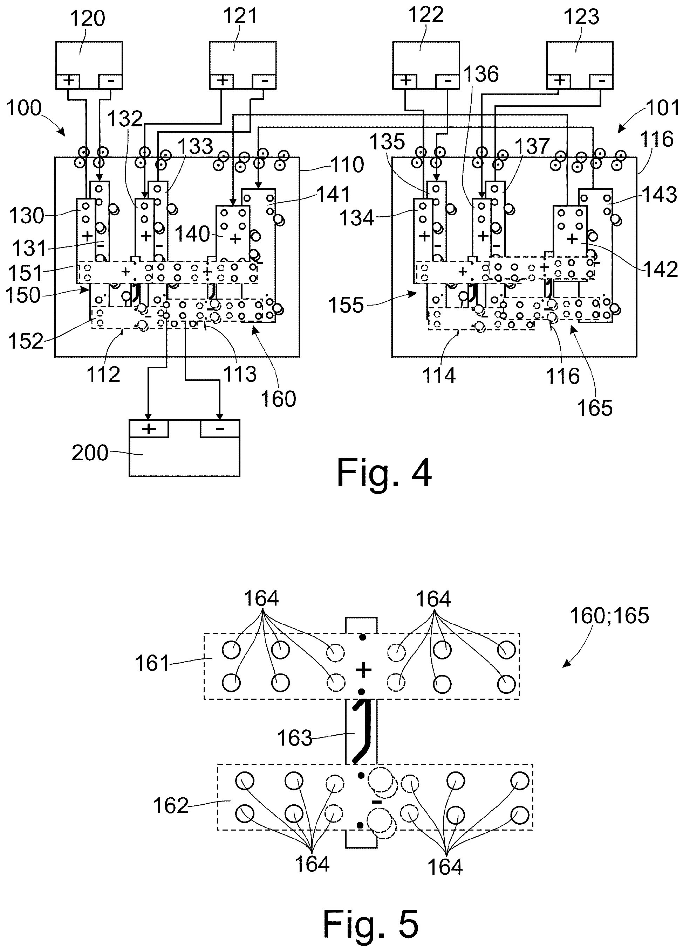

Fig. 4 zeigt beispielhaft eine mögliche Ausführungsform eines erfindungsgemäßen Systems 300 zum Prüfen von Batterien 200, 201, welches einen Batterieprüfstand 100 und einen weiteren Batterieprüfstand 101 umfasst, wobei der weitere Batterieprüfstand 101 identisch zum Batterieprüfstand 100 ist.

Wie zu sehen ist, ist bei jedem Batterieprüfstand 100, 101 jeweils die Schienenbrücke 150, 155 montiert.

Weiterhin ist auch jeweils eine zusätzliche Schienenbrücke 160, 161 montiert. Diese zusätzlichen Schienenbrücken 160, 161 unterscheiden sich von den Schienenbrücken 150, 155 und ermöglichen es, die weiteren Leistungsquellen 122, 123 des weiteren Batterieprüfstands 101 zu den zwei Leistungsquellen 120, 121 des Batterieprüfstands 100 parallel zu schalten, so dass die zu prüfende Batterie 200 mit dem theoretisch 4-fachen elektrischen Strom der einzelnen Leistungsquellen 120, 121, 122, 123 geprüft werden kann.

Im ausgewählten Betriebsmodus der Fig. 4 müssen sowohl die zwei ersten Schalter 112, 114 als auch die zwei zweiten Schalter 113, 115 betätigt werden, um eine Sperrung der zwei Leistungsquellen 120, 121 und der zwei weiteren Leistungsquellen 122, 123 aufzuheben.

Die Betätigung der ersten Schalter 112, 114 erfolgt dabei automatisch bei korrekter Montage der Schienenbrücken 150, 155. Die Betätigung der zweiten Schalter 113, 115 erfolgt automatisch bei korrekter Montage der zusätzlichen Schienenbrücken 160, 165.

Eine zusätzliche Schienenbrücke 160 ist dabei beispielhaft in Fig. 5 gezeigt. Wie zu sehen ist, weist auch die zusätzliche Schienenbrücke 160 ein definiertes Muster an Öffnungen 164 auf, wobei ein erster Anteil der Öffnungen 164 zur Kontaktierung der zwei zusätzlichen Stromschienen 140, 141 an deren Kontaktstellen ausgebildet ist, wobei ein zweiter Anteil der Öffnungen 164 zur Kontaktierung der mindestens einen Schienenbrücke 150, 155 ausgebildet ist und wobei ein dritter Anteil der Öffnungen 164 als Kontaktstellen zur elektrischen Verbindung mit der zu prüfenden Batterie 200 ausgebildet ist.

Die zusätzliche Schienenbrücke 160 weist einen Pluspfad 161 und einen Minuspfad 162 auf, wobei der Pluspfad 161 und der Minuspfad 162 über ein Verbindungselement 163 aus nicht leitendem Material gehalten und zueinander beabstandet sind.

Beispielsgemäß können die zusätzlichen Schienenbrücken 160, 165 über den ersten Anteil der Öffnungen 164 dabei mit den zusätzlichen Stromschienen 140, 141 bzw. 142, 143 verschraubt werden. Über den zweiten Anteil der Öffnungen 164 können die zusätzlichen Schienenbrücken 160, 165 mit den Stromschienen 130, 131, 132, 133 bzw. 134, 135, 136, 137 verschraubt werden.

Auch die Prüfzelle 110 weist Führungsbolzen zur Platzierung der zusätzlichen Schienenbrücke 160 auf.

In analoger Weise weist die Prüfzelle 116 Führungsbolzen zur Platzierung der Stromschienen 134, 135, 136, 137, der Schienenbrücke 155 und der zusätzlichen Schienenbrücke 165 auf.

### Bezugszeichen

- 100: Batterieprüfstand
- 101: weiterer Batterieprüfstand
- 110: Prüfzelle (des Batterieprüfstands 100)
- 112: erster Schalter (in Prüfzelle 110)
- 113: zweiter Schalter (in Prüfzelle 110)
- 114: erster Schalter (in Prüfzelle 116 des weiteren Batterieprüfstands 101)
- 115: zweiter Schalter (in Prüfzelle 116 des weiteren Batterieprüfstands 101)
- 116: Prüfzelle (des weiteren Batterieprüfstands 101)
- 120, 121: elektrische Leistungsquellen (Gleichspannungs- bzw. stromquellen)
- 122, 123: weitere elektrische Leistungsquellen (Gleichspannungs- bzw. stromquellen des Batterieprüfstands 101)
- 130, 131, 132, 133: Stromschienen (in Prüfzelle 110)
- 134, 135, 136, 137: Stromschienen (in Prüfzelle 116)
- 140, 141: zusätzliche Stromschienen (in Prüfzelle 110 mit größerer Querschnittsfläche)
- 142, 143: zusätzliche Stromschienen (in Prüfzelle 116 mit größerer Querschnittsfläche)
- 150, 155: Schienenbrücken
- 151: Pluspfad der Schienenbrücke 150
- 152: Minuspfad der Schienenbrücke 150
- 153: Verbindungselement (aus nicht leitendem Material, zur Positionierung von Plus- und Minuspfad)
- 154: Öffnungen (in Schienenbrücke 150, zur Kontaktierung der Stromschienen und Batterien)
- 160, 161, 165: zusätzliche Schienenbrücken
- 161: Pluspfad der zusätzlichen Schienenbrücke 160
- 162: Minuspfad der zusätzlichen Schienenbrücke 160
- 163: Verbindungselement (aus nicht leitendem Material , zur Positionierung von Plus- und Minuspfad der zusätzlichen Schienenbrücke 160)
- 164: Öffnungen (in zusätzlichen Schienenbrücken 160, zur Kontaktierung der zusätzlichen Stromschienen, Schienenbrücken und Batterien)
- 200, 201: Batterien
- 300: System zum Prüfen von Batterien (umfassend Batterieprüfstände 100 und 101)

## Patentansprüche

1. Batterieprüfstand (100) zum Prüfen von Batterien (200, 201), wobei der Batterieprüfstand (100) eine Prüfzelle (110), mindestens zwei elektrische Leistungsquellen (120, 121) und mindestens vier Stromschienen (130, 131, 132, 133) umfasst, wobei die mindestens zwei elektrischen Leistungsquellen (120, 121) jeweils zur Bereitstellung einer elektrischen Spannung und zur Bereitstellung eines elektrischen Stroms ausgebildet sind und wobei die mindestens vier Stromschienen (130, 131, 132, 133) zur elektrischen Verbindung der mindestens zwei elektrischen Leistungsquellen (120, 121) mit jeweils einer zu prüfenden Batterie (200, 201) ausgebildet sind, wobei die Prüfzelle (110) zur Aufnahme und Anordnung der mindestens vier Stromschienen (130, 131, 132, 133) ausgebildet ist,
**dadurch gekennzeichnet, dass** der Batterieprüfstand (100) weiterhin mindestens eine Schienenbrücke (150, 155) umfasst, wobei die mindestens eine Schienenbrücke (150, 155) dazu ausgebildet ist, eine Batterie (200, 201) gleichzeitig mit den mindestens zwei elektrischen Leistungsquellen (120, 121) zu verbinden, so dass die mindestens zwei elektrischen Leistungsquellen (120, 121) parallel geschaltet sind.

2. Batterieprüfstand (100) nach Anspruch 1,
**dadurch gekennzeichnet, dass** die mindestens eine Schienenbrücke (150, 155) einen Pluspfad (151) und einen Minuspfad (152) aufweist, wobei der Pluspfad (151) und der Minuspfad (152) über ein Verbindungselement (153) aus nicht leitendem Material gehalten und zueinander beabstandet sind.

3. Batterieprüfstand (100) nach Anspruch 2,
**dadurch gekennzeichnet, dass** die mindestens eine Schienenbrücke (150, 155) ein definiertes Muster an Öffnungen (154) aufweist, wobei ein erster Anteil der Öffnungen (154) zur Kontaktierung der mindestens vier Stromschienen (130, 131, 132, 133) an deren Kontaktstellen ausgebildet ist und wobei ein zweiter Anteil der Öffnungen (154) als Kontaktstellen zur elektrischen Verbindung mit einer zu prüfenden Batterie (200, 201) ausgebildet ist.

4. Batterieprüfstand (100) nach mindestens einem der Ansprüche 1 bis 3,
**dadurch gekennzeichnet, dass** die mindestens eine Schienenbrücke (150, 155) über den ersten Anteil der Öffnungen (154) mit den Kontaktstellen der mindestens vier Stromschienen (130, 131, 132, 133) verschraubbar ist.

5. Batterieprüfstand (100) nach Anspruch 4, **dadurch gekennzeichnet, dass** die Prüfzelle (110) Führungsbolzen zur Platzierung der mindestens einen Schienenbrücke (150, 155) aufweist.

6. Batterieprüfstand (100) nach mindestens einem der Ansprüche 1 bis 5,
**dadurch gekennzeichnet, dass** der Batterieprüfstand (100) zwei zusätzliche Stromschienen (140, 141) aufweist, welche jeweils eine größere Querschnittsfläche aufweisen als jede der mindestens vier Stromschienen (130, 131, 132, 133), wobei die zwei zusätzlichen Stromschienen (140, 141) dazu ausgebildet sind, mit insgesamt zwei Leistungsquellen (120, 121) elektrisch verbunden zu werden.

7. Batterieprüfstand (100) nach mindestens einem der Ansprüche 1 bis 6,
**dadurch gekennzeichnet, dass** der Batterieprüfstand (100) eine zusätzliche Schienenbrücke (160, 161, 165) umfasst, wobei die zusätzliche Schienenbrücke (160, 161, 165) dazu ausgebildet ist, die Batterie (200, 201) zusätzlich mit weiteren Leistungsquellen (122, 123) eines weiteren Batterieprüfstands (101) zu verbinden, so dass die mindestens zwei elektrischen Leistungsquellen (120, 121) und die weiteren Leistungsquellen (122, 123) parallel geschaltet sind.

8. Batterieprüfstand (100) nach Anspruch 7,
**dadurch gekennzeichnet, dass** die zusätzliche Schienenbrücke (160, 161, 165) ein definiertes Muster an Öffnungen (164) aufweist, wobei ein erster Anteil der Öffnungen (164) zur Kontaktierung der zwei zusätzlichen Stromschienen (140, 141) an deren Kontaktstellen ausgebildet ist, wobei ein zweiter Anteil der Öffnungen (164) zur Kontaktierung der mindestens einen Schienenbrücke (150, 155) ausgebildet ist und wobei ein dritter Anteil der Öffnungen (164) als Kontaktstellen zur elektrischen Verbindung mit einer zu prüfenden Batterie (200, 201) ausgebildet ist.

9. Batterieprüfstand (100) nach Anspruch 8,
**dadurch gekennzeichnet, dass** die zusätzliche Schienenbrücke (160, 161, 165) über den ersten Anteil der Öffnungen (164) mit den Kontaktstellen der zwei zusätzlichen Stromschienen (140, 141) verschraubbar ist und über den zweiten Anteil der Öffnungen (164) mit den Kontaktstellen der mindestens einen Schienenbrücke (150, 155) verschraubbar ist.

10. Batterieprüfstand (100) nach mindestens einem der Ansprüche 8 und 9,
**dadurch gekennzeichnet, dass** die Prüfzelle (110) Führungsbolzen zur Platzierung der zusätzlichen Schienenbrücke (160, 161, 165) aufweist.

11. Batterieprüfstand (100) nach mindestens einem der Ansprüche 8 bis 10,
**dadurch gekennzeichnet, dass** der Batterieprüfstand (100) einen ersten Schalter (112, 114) aufweist, welcher bei einer Platzierung der mindestens einen Schienenbrücke (150, 155) automatisiert betätigt wird, und/oder dass der Batterieprüfstand (100) einen zweiten Schalter (113, 115) aufweist, welcher bei einer Platzierung der zusätzlichen Schienenbrücke (160, 161, 165) automatisiert betätigt wird, wobei bei einer Betätigung des ersten Schalters (112, 114) eine Sperrung der mindestens zwei elektrischen Leistungsquellen (120, 121) aufgehoben wird und wobei bei einer Betätigung des zweiten Schalters (113, 115) eine Sperrung der weiteren Leistungsquellen (122, 123) aufgehoben wird.

12. Batterieprüfstand (100) nach mindestens einem der Ansprüche 1 bis 11,
**dadurch gekennzeichnet, dass** der Batterieprüfstand (100) Spannungsmessstreckenvorrichtungen aufweist, welche dazu ausgebildet sind, Spannungsmesswerte der Stromschienen (130, 131, 132, 133, 140, 141) und der mindestens einen Schienenbrücke (150, 155, 160, 161, 165) zu erfassen und bei unerwarteten Spannungsmesswerten die Leistungsquellen (120, 121, 122, 123) zu sperren.

13. Batterieprüfstand (100) nach mindestens einem der Ansprüche 1 bis 12,
**dadurch gekennzeichnet, dass** der Batterieprüfstand (100) eine transparente Schutzabdeckung umfasst, welche alle stromführenden Bauteile nach Öffnen einer Zugangstür berührungssicher abdeckt und fingersichere Öffnungen aufweist, um Spannungsmessungen im gesicherten Zustand zu ermöglichen.

14. System (300) zum Prüfen von Batterien,
umfassend mindestens zwei Batterieprüfstände (100, 101) nach mindestens einem der Ansprüche 1 bis 13.

15. System (300) nach Anspruch 14,
**dadurch gekennzeichnet, dass** die mindestens zwei Batterieprüfstände (100, 101) identisch ausgebildet sind.
